# EUROPÄISCHE PATENTANMELDUNG

(11) **EP 3 748 674 A1**
(43) Veröffentlichungstag der Anmeldung: **09.12.2020**
(21) Anmeldenummer: 19178187.1
(22) Anmeldetag: 04.06.2019
(51) Int. Cl.: H01L 23/64, H01L 25/07

(54) **LEISTUNGSHALBLEITERMODUL MIT MINIMALER INDUKTIVER KOPPLUNG VON ANSCHLUSSELEMENTEN**

(71) Anmelder: Siemens Aktiengesellschaft, 80333 München (DE)
(72) Erfinder: Kneißl, Philipp, 90768 Fürth (DE); Lorz, Roland, 91341 Röttenbach (DE); Mauersberger, Markus, 90427 Nürnberg (DE); Nöth, Christoph, 90491 Nürnberg (DE); Zeyß, Felix, 90408 Nürnberg (DE)

(57) **Zusammenfassung**

Ein Leistungshalbleitermodul weist einen Schaltungsträger (1) auf, auf der mindestens eine Halbbrücke angeordnet ist, die zwei Enden (2, 2') aufweist, die über mindestens zwei elektrisch in Reihe geschaltete Halbleiterschalter (3, 3') elektrisch miteinander verbunden sind. Das Leistungshalbleitermodul weist mehrere als Stanz-Biege-Teile ausgebildete Anschlusselemente (6, 6', 6") auf, wobei die Enden (2, 2') der Halbbrücke mit jeweils mindestens einem Anschlusselement (6, 6', 6") elektrisch verbunden sind. Die Anschlusselemente (6, 6', 6") weisen Anschlussflächen (7, 7', 7") zum Anschluss von Stromschienen (8, 8', 8") auf. Die Anschlussflächen (7, 7', 7") sind in einer Versatzrichtung um einen Seitenversatz (δy) gegeneinander versetzt angeordnet. Die Anschlussflächen (7, 7', 7") sind parallel zum Schaltungsträger (1) orientiert. Die Anschlusselemente (6, 6', 6") weisen weiterhin zusätzlich zu den Anschlussflächen (7, 7', 7") zum Schaltungsträger (1) hin parallel zum Schaltungsträger (1) orientierte Verbindungsflächen (13, 13', 13") auf, so dass die Anschlussflächen (7, 7', 7") über die Verbindungsflächen (13, 13', 13") elektrisch mit dem Schaltungsträger (1) verbunden sind. Die Anschlussflächen (7, 7', 7") und die Verbindungsflächen (13, 13', 13") sind über Zwischenflächen (14, 14', 14") mechanisch und elektrisch miteinander verbunden. In der Versatzrichtung gesehen ist zwischen je zwei unmittelbar benachbarten Anschlusselementen (6, 6', 6") je eine Zwischenfläche (14, 14', 14") dieser beiden Anschlusselemente (6, 6', 6") angeordnet.

## Beschreibung

Die vorliegende Erfindung geht aus von einem Leistungshalbleitermodul,
- wobei das Leistungshalbleitermodul einen Schaltungsträger aufweist,
- wobei auf dem Schaltungsträger mindestens eine Halbbrücke angeordnet ist,
- wobei die Halbbrücke zwei Enden aufweist, die über mindestens zwei elektrisch in Reihe geschaltete Halbleiterschalter elektrisch miteinander verbunden sind,
- wobei das Leistungshalbleitermodul eine Mehrzahl von als jeweiliges Stanz-Biege-Teil ausgebildeten Anschlusselementen aufweist,
- wobei die Enden der Halbbrücke mit jeweils mindestens einem der Anschlusselemente elektrisch verbunden sind,
- wobei die Anschlusselemente eine jeweilige Anschlussfläche zum Anschluss einer jeweiligen Stromschiene aufweisen,
- wobei die Anschlussflächen in einer Versatzrichtung um einen Seitenversatz gegeneinander versetzt angeordnet sind,
- wobei die Anschlussflächen der Anschlusselemente parallel zum Schaltungsträger orientiert sind,
- wobei die Anschlusselemente zusätzlich zur jeweiligen Anschlussfläche zum Schaltungsträger hin jeweils eine parallel zum Schaltungsträger orientierte Verbindungsfläche aufweisen, so dass die jeweilige Anschlussfläche über die jeweilige Verbindungsfläche elektrisch mit dem Schaltungsträger verbunden ist,
- wobei die jeweilige Anschlussfläche und die jeweilige Verbindungsfläche über jeweils mindestens eine Zwischenfläche mechanisch und elektrisch miteinander verbunden sind.

Leistungshalbleitermodule - nachfolgend stets nur kurz als Module bezeichnet - werden, sofern sie eine nennenswerte Leistung schalten sollen, über Stromschienen mit elektrischer Energie versorgt. Die Stromschienen werden an den Anschlussflächen in der Regel mittels Schraubverbindungen befestigt. Dies gilt sowohl für die eingangsseitigen Anschlüsse des Moduls, über welche dem Modul zumindest ein positives und ein negatives Gleichspannungspotenzial zugeführt werden, als auch für den ausgangsseitigen Anschluss, über den die geschaltete Spannung abgegeben wird. Die vorliegende Erfindung betrifft die eingangsseitigen Anschlüsse des Moduls.

Aufgrund von steigenden Taktfrequenzen, geforderten Flankensteilheiten, Spannungen und Strömen steigen im Modul die Anforderungen an die Qualität der Verbindung zwischen den Anschlussflächen und den elektrischen und elektronischen Strukturen innerhalb des Moduls, insbesondere zu den Halbleiterschaltern hin. Insbesondere sollte die Anbindung möglichst niederinduktiv sein. Die Anbindung wird hierbei umso schwieriger, je mehr verschiedene Potenziale dem Modul zugeführt werden sollen.

Die Aufgabe der vorliegenden Erfindung besteht darin, die Induktivität der Stromführung innerhalb des Moduls zu optimieren.

Die Aufgabe wird durch ein Leistungshalbleitermodul mit den Merkmalen des Anspruchs 1 gelöst. Vorteilhafte Ausgestaltungen des Leistungshalbleitermoduls sind Gegenstand der abhängigen Ansprüche 2 bis 7.

Erfindungsgemäß wird ein Leistungshalbleitermodul der eingangs genannten Art dadurch ausgestaltet, dass in der Versatzrichtung gesehen zwischen je zwei in Versatzrichtung unmittelbar benachbarten Anschlusselementen je eine Zwischenfläche dieser beiden Anschlusselemente angeordnet ist. Insbesondere durch diese Ausgestaltung kann die induktive Kopplung der Anschlusselemente miteinander gering gehalten werden. Weiterhin ergibt sich eine gleichmäßige induktive Kopplung der Anschlussflächen miteinander.

Im Minimalfall beträgt die Anzahl an Anschlusselementen exakt zwei. In diesem Fall ist die Anzahl an Zwischenflächen pro Anschlusselement vorzugsweise exakt eins, also weder 0 (das sowieso nicht) noch 2, 3 oder noch größer.

Alternativ ist es möglich, dass die Anzahl an Anschlusselementen größer als zwei ist. In diesem Fall rahmen in der Versatzrichtung gesehen zwei äußere Anschlusselemente mindestens ein mittleres Anschlusselement ein. In diesem Fall ist weiterhin die Anzahl an Zwischenflächen pro äußerem Anschlusselement - wie zuvor - exakt eins. Die Anzahl an Zwischenflächen pro mittlerem Anschlusselement hingegen ist vorzugsweise exakt zwei, nämlich je eine Zwischenfläche zu den beiden benachbarten Anschlusselementen hin.

Sofern mittlere Anschlusselemente vorhanden sind, weisen die Anschlussflächen der mittleren Anschlusselemente vorzugsweise jeweils ein unteres und ein oberes Flächenelement auf. Das jeweilige untere und das jeweilige obere Flächenelement sind übereinander angeordnet, so dass das untere Flächenelement zwischen dem oberen Flächenelement und der Verbindungsfläche des jeweiligen mittleren Anschlusselements angeordnet ist, das untere und das obere Flächenelement aber zumindest nach dem Verbinden mit der jeweiligen Stromschiene flächig aneinander anliegen. Weiterhin ist in diesem Fall je eines der beiden Flächenelemente mit je einer der beiden Zwischenflächen des jeweiligen mittleren Anschlusselements mechanisch und elektrisch verbunden. Durch diese Ausgestaltung ergibt sich eine besonders einfache Fertigung des entsprechenden mittleren Anschlusselements.

Die Anschlussflächen für die Gleichspannungspotenziale liegen üblicherweise auf der gleichen Höhe. Die Stromschienen für die (mindestens zwei) Gleichspannungspotenziale werden in der Regel übereinander gelegt und gemeinsam geführt, wobei zwischen den verschiedenen Stromschienen Isolierschichten angeordnet sind. Sollen die Stromschienen an die Anschlussflächen angeschlossen werden, muss mindestens eine der Stromschienen gebogen und gekrümmt werden, damit sie auf der gleichen Höhe wie die andere Stromschiene zu liegen kommt. Diese Ausgestaltung erhöht die Induktivität der Energieversorgung auf der Gleichspannungsseite und ist daher von Nachteil. Weiterhin ist sie fertigungstechnisch arbeitsaufwändig und damit teuer. Weiterhin müssen die Stromschienen lange Finger aufweisen, um den Höhenversatzausgleichen zu können. Bei hohen Materialdicken sind weiterhin die erforderlichen Umformungsradien hoch.

Im Stand der Technik sind Module bekannt, bei denen Hilfsanschlüsse - beispielsweise zur Ansteuerung der Halbleiterschalter oder zur Rückmeldung eines ausgangsseitig erfassten geschalteten Stroms - gegenüber den Anschlussflächen zum Zuführen der Gleichspannungspotenziale auf einem anderen Höhenniveau liegen. Die Anschlussflächen zum Zuführen der Gleichspannungspotenziale liegen jedoch stets auf demselben Niveau.

Im Stand der Technik ist weiterhin bekannt, Höhenunterschiede durch zusätzliche Leiterplatten auszugleichen, so dass die Finger der Stromschienen indirekt über die zusätzlichen Leiterplatten mit dem Modul verbunden sind. Die zusätzlichen Leiterplatten können aber keine hohen Ströme tragen.

Zur Vermeidung dieses Nachteils ist in einer vorteilhaften Ausgestaltung des Moduls vorgesehen,
- dass orthogonal zu den Anschlussflächen verlaufende Normalenvektoren parallel zueinander verlaufen und
- dass die Anschlussflächen in Richtung der Normalenvektoren gesehen zumindest teilweise um einen Höhenversatz gegeneinander versetzt angeordnet sind.

Dadurch ist es im Idealfall möglich, die Stromschienen direkt und unmittelbar - ohne vorheriges Biegen - anzuschließen. Selbst wenn ein Biegen erforderlich ist, kann dieses Biegen deutlich reduziert werden. Dadurch vereinfacht sich weiterhin auch die Isolierung der Stromschienen voneinander.

Der Höhenversatz sollte an die Dicke der Stromschienen angepasst sein. Entsprechend der Dicke der Stromschienen beträgt der Höhenversatz vorzugsweise minimal 3 mm und/oder maximal 25 mm. Noch besser ist ein Höhenversatz von minimal 8 mm oder 10 mm und/oder maximal 15 mm oder 20 mm.

Vorzugsweise sind in Richtung der Normalenvektoren gesehen auf gleicher Höhe liegende Anschlussflächen über den Schaltungsträger elektrisch miteinander kurzgeschlossen. Dadurch ist es möglich, dem Modul die erforderlichen Ströme über mehrere Anschlusselemente zuzuführen und so den Stromfluss pro Anschlusselement relativ niedrig zu halten.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: ein Leistungshalbleitermodul in einer Draufsicht,
- FIG 2: zwei Anschlusselemente in einer perspektivischen Ansicht,
- FIG 3: ein Leistungshalbleitermodul mit Anschlusselementen und Stromschienen in einer Seitenansicht,
- FIG 4: Stromschienen in einer Seitenansicht,
- FIG 5: eine Stromschiene in einer Draufsicht,
- FIG 6: eine weitere Stromschiene in einer Draufsicht,
- FIG 7: ein Leistungshalbleitermodul in einer Frontansicht,
- FIG 8: ein weiteres Leistungshalbleitermodul in einer Draufsicht,
- FIG 9: ein weiteres Leistungshalbleitermodul in einer Draufsicht,
- FIG 10: das Leistungshalbleitermodul von FIG 8 in einer Frontansicht,
- FIG 11: das Leistungshalbleitermodul von FIG 9 in einer Frontansicht und
- FIG 12: drei Anschlusselemente in einer perspektivischen Ansicht.

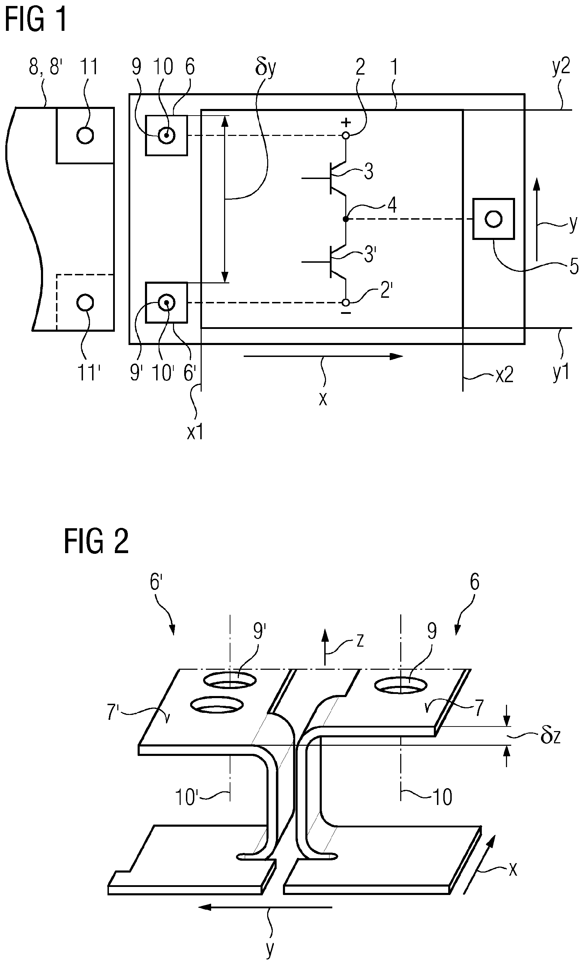

Gemäß FIG 1 weist ein Leistungshalbleitermodul einen Schaltungsträger 1 auf. Der Schaltungsträger 1 kann beispielsweise aus Keramik bestehen oder als Leiterplatte (beispielsweise aus FR4) ausgebildet sein. Auf dem Schaltungsträger 1 ist mindestens eine Halbbrücke angeordnet. Die Halbbrücke weist zwei Enden 2, 2' auf, die über (mindestens) zwei Halbleiterschalter 3, 3' elektrisch miteinander verbunden sind. Die Halbleiterschalter 3, 3' können beispielsweise als IGBTs oder als MOSFETs ausgebildet sein. Die beiden Halbleiterschalter 3, 3' sind elektrisch in Reihe geschaltet. Zwischen den beiden Halbleiterschaltern 3, 3' befindet sich daher ein Knotenpunkt 4.

Den beiden Enden 2, 2' werden in der Regel ein positives und ein negatives Potenzial zugeführt, in FIG 1 durch "+" und "-" angedeutet. Die beiden Halbleiterschalter 3, 3' werden in der Regel derart betrieben das entweder beide Halbleiterschalter 3, 3' gesperrt sind, so dass der Knotenpunkt 4, bezogen auf die beiden Potenziale "+" und "-", hochohmig ist, oder dass einer der beiden Halbleiterschalter 3, 3' durchgeschaltet und der andere der beiden Halbleiterschalter 3, 3' gesperrt ist, so dass eines der beiden Potenziale "+" und "-" auf den Knotenpunkt 4 durchgeschaltet wird.

Das am Knotenpunkt 4 jeweils anstehende Potenzial wird über ein Anschlusselement 5 abgegeben. Das Anschlusselement 5 ist zu diesem Zweck mit dem Knotenpunkt 4 elektrisch verbunden. Die elektrische Verbindung ist in FIG 1 durch eine entsprechende gestrichelte Linie angedeutet. Das Anschlusselement 5 - also das direkt, ohne zwischen geordneten Halbleiterschalter 3, 3' mit dem Knotenpunkt 4 verbundene Anschlusselement 5 - ist nicht Gegenstand der vorliegenden Erfindung.

Die beiden Potenziale "+" und "-" werden den Enden 2, 2' der Halbbrücke über Anschlusselemente 6, 6' zugeführt. Die Enden 2, 2' der Halbbrücke sind daher mit jeweils mindestens einem der Anschlusselemente 6, 6' elektrisch verbunden. Die elektrische Verbindung ist in FIG 1 durch entsprechende gestrichelte Linien angedeutet. Die Anschlusselemente 6, 6' - also die Anschlusselemente, die mit dem Knotenpunkt 4 über einen Halbleiterschalter 3, 3' verbunden sind - sind Gegenstand der vorliegenden Erfindung.

Die Anschlusselemente 6, 6' sind, bezogen auf den Schaltungsträger 1, auf der anderen Seite des Leistungshalbleitermoduls angeordnet als das Anschlusselement 5. Wenn also der Schaltungsträger 1 sich beispielsweise in einer mit x bezeichneten Längsrichtung von x1 bis x2 erstreckt (mit x2 > x1), so ist in Längsrichtung x gesehen beispielsweise das Anschlusselement 5 in etwa bei x2 angeordnet, die Anschlusselemente 6, 6' in etwa bei x1. Hierbei ist es möglich, dass die Anschlusselemente 6, 6' in Längsrichtung x gesehen auf der gleichen Höhe angeordnet sind. Es ist aber auch möglich, dass sie in Längsrichtung x gesehen geringfügig gegeneinander versetzt sind.

Der Schaltungsträger 1 erstreckt sich weiterhin in einer zur x-Richtung orthogonalen Querrichtung y von y1 bis y2. Die Orte der Anschlusselemente 6, 6' liegen in y-Richtung gesehen meist zwischen y1 und y2. Gleiches gilt, nebenbei bemerkt, in der Regel auch für das Anschlusselement 5.

Die Anschlusselemente 6, 6' sind entsprechend der Darstellung in FIG 2 als Stanz-Biege-Teile ausgebildet. Die Anschlusselemente 6, 6' weisen eine jeweilige Anschlussfläche 7, 7' auf. An die Anschlussflächen 7, 7' werden entsprechend der Darstellung in FIG 1 Stromschienen 8, 8' angeschlossen, um den Enden 2, 2' der Halbbrücke über die Anschlusselemente 6, 6' die entsprechenden Potenziale "+" und "-" zuzuführen. Die Stromschienen 8, 8' liegen in der Darstellung von FIG 1 übereinander.

Die Anschlussflächen 7, 7' weisen oftmals jeweils eine Durchgangsbohrung 9, 9' auf. Die Durchgangsbohrungen 9, 9' können im Einzelfall als Gewindebohrungen ausgebildet sein. In der Regel sind sie aber als einfache Bohrungen ohne Gewinde ausgebildet. Die Durchgangsbohrungen 9, 9' erstrecken sich in Richtung einer jeweiligen Bohrungsachse 10, 10'. Die Bohrungsachsen 10, 10' sind in der Regel orthogonal zu der durch die Längsrichtung x und die Querrichtung y aufgespannte Ebene. In jedem Fall aber sind die Bohrungsachsen 10, 10' orthogonal zur jeweiligen Anschlussfläche 7, 7' orientiert und verlaufen daher parallel zu Normalenvektoren, die orthogonal zu den Anschlussflächen 7, 7' orientiert sind. Weiterhin verlaufen die Normalenvektoren parallel zueinander. Die Richtung der Normalenvektoren wird nachstehend als Höhenrichtung z bezeichnet. Es wird darauf hingewiesen, dass die Längsrichtung x, die Querrichtung y und die Höhenrichtung z in der Regel ein rechtshändiges, rechtwinkliges kartesisches Koordinatensystem bilden. Dies ist aufgrund des Umstands, dass die Höhenrichtung z nicht zwangsweise orthogonal zur Längsrichtung x und/oder der Querrichtung y ist, jedoch nicht zwingend der Fall.

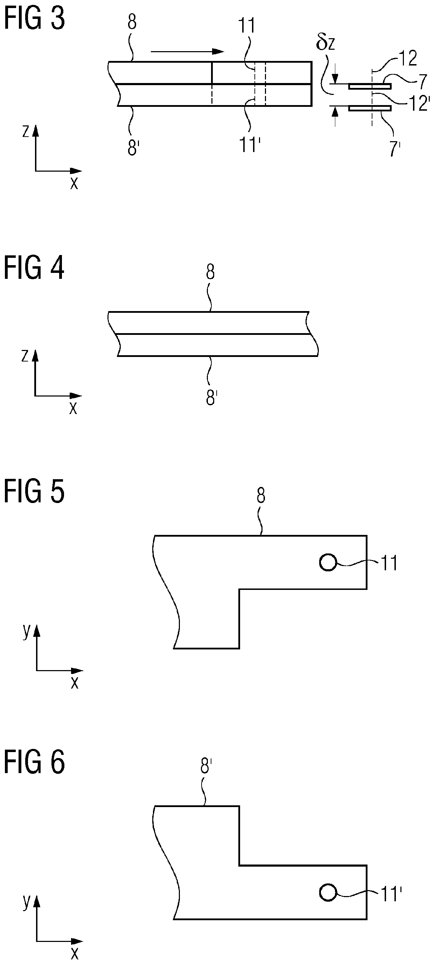

Die Stromschienen 8, 8' weisen in der Regel ebenfalls Durchgangsbohrungen 11, 11' auf. Die Durchgangsbohrungen 11, 11' der Stromschienen 8, 8' sind in der Regel ebenfalls als einfache Bohrungen ohne Gewinde ausgebildet. Es ist daher möglich, die Stromschienen 8, 8' mittels Schraubverbindungen 12, 12' (angedeutet in FIG 3 als gestrichelte Linien) im Bereich der Anschlussflächen 7, 7' mit den Anschlusselementen 6, 6' elektrisch und mechanisch zu verbinden. Die Schraubverbindungen 12, 12' werden zu diesem Zweck durch die Durchgangsbohrungen 9, 9' der Anschlussflächen 7, 7' und auch durch die Durchgangsbohrungen 11, 11' der Stromschienen 8, 8' geführt. Diese Art der Verbindung ist die häufigste. Prinzipiell sind aber auch andersartige Verbindungen möglich, beispielsweise mittels anderer Verbindungselemente, mittels einer Klemmverbindung durch Schweißen, durch Toxen und andere mehr.

Wie aus den FIG 1 und 2 ohne weiteres ersichtlich ist, sind die Anschlussflächen 7, 7' orthogonal zur Höhenrichtung z gesehen um einen Seitenversatz δy gegeneinander versetzt angeordnet. Insbesondere zeigt der Seitenversatz δy in der Regel in die Querrichtung y. In der Richtung, in die der Seitenversatz δy zeigt, sind die Anschlussflächen 7, 7' ersichtlich einer Reihe nebeneinander angeordnet.

Die Stromschienen 8, 8' verlaufen entsprechend der Darstellung in FIG 4 im Wesentlichen deckungsgleich übereinander. Lediglich in Bereichen, in denen sie mit den Anschlussflächen 7, 7' verbunden werden sollen, befinden sich Ausschnitte. Insbesondere zeigt FIG 5 die in FIG 4 obere Stromschiene 8, FIG 6 die FIG 4 untere Stromschiene 8'. Um trotz der Anordnung der Stromschienen 8, 8' übereinander eine Verbindung der Stromschienen 8, 8' mit den Anschlussflächen 7, 7' zu ermöglichen, ohne eine oder beide der Stromschienen 8, 8' biegen zu müssen, sind die Anschlussflächen 7, 7' entsprechend der Darstellung in den FIG 2, 3 und 7 in Höhenrichtung z gesehen um einen Höhenversatz δz gegeneinander versetzt angeordnet. Der Höhenversatz δz beträgt - entsprechend der üblichen Dicken der Stromschienen 8, 8' vorzugsweise minimal 3 mm und/oder maximal 25 mm. In der Regel liegt der Höhenversatz δz minimal bei 8 mm oder 10 mm und/oder maximal bei 15 mm oder 20 mm.

Aus den obenstehenden Ausführungen ist ersichtlich, dass das Leistungshalbleitermodul weitere Anschlusselemente aufweisen kann, die jedoch nicht mit den Anschlusselementen 6, 6', die Gegenstand der vorliegenden Erfindung sind, in der Versatzrichtung gesehen exakt oder nahezu in einer Reihe liegen. Konkret ist entsprechend der bisher erläuterten Ausgestaltung das Anschlusselement 5 ein derartiges weiteres Anschlusselement. Diese Anschlusselemente 5, die nicht Gegenstand der vorliegenden Erfindung sind, können nach Bedarf sowohl untereinander als auch bezüglich der Anschlusselemente 6, 6' - also derjenigen Anschlusselemente 6, 6', die in der Versatzrichtung gesehen exakt oder nahezu in einer Reihe liegen - auf der gleichen Höhe oder auf verschiedenen Höhen liegen.

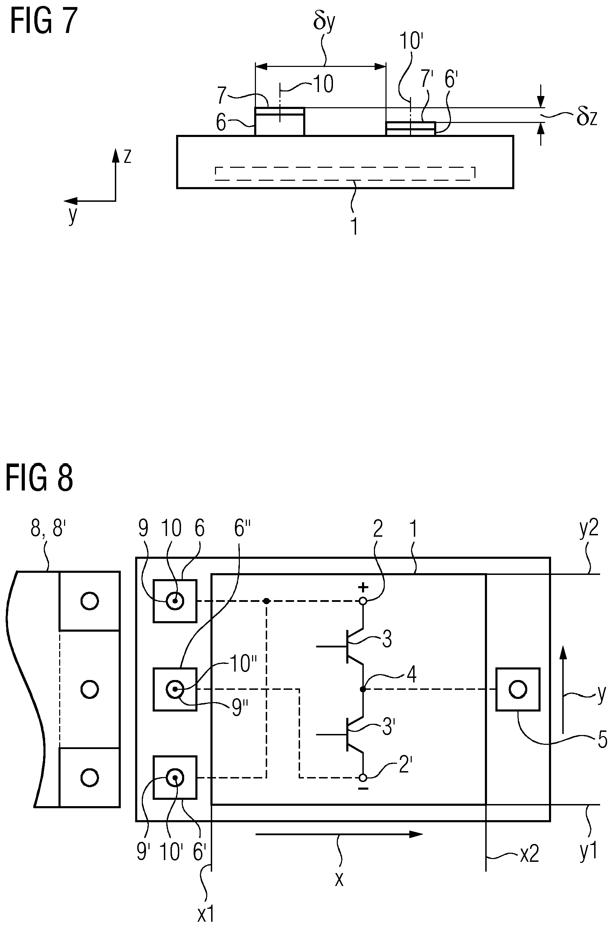

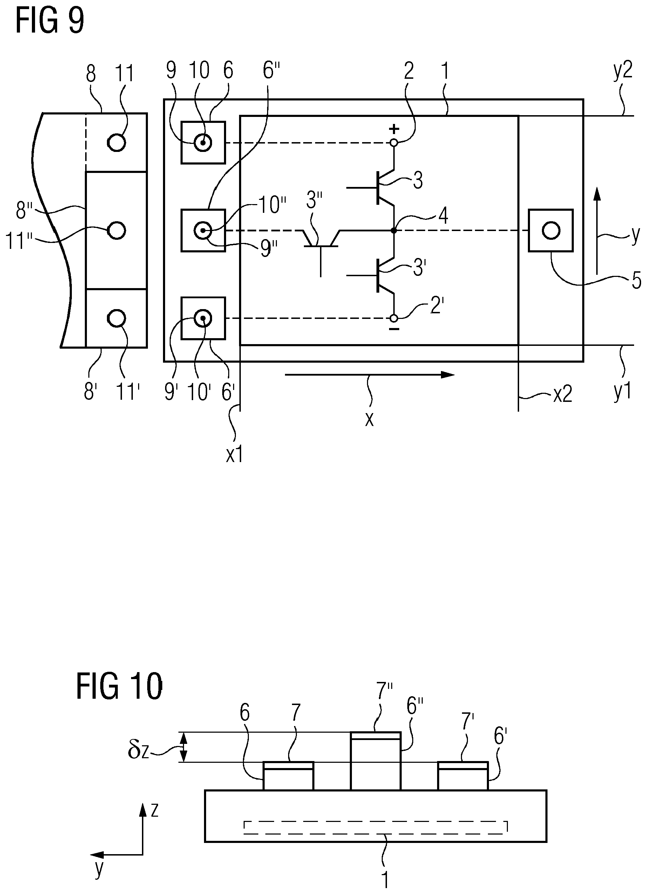

Obenstehend wurde in Verbindung mit den FIG 2 bis 7 die Minimalausgestaltung erläutert, bei der (bezüglich der erfindungsgemäßen Ausgestaltung) exakt zwei Anschlusselemente 6, 6' vorhanden sind. Im Falle von exakt zwei Anschlusselementen 6, 6' ist je eines der beiden Anschlusselemente 6, 6' mit je einem der Enden 2, 2' der Halbbrücke elektrisch verbunden. Es sind aber auch Ausgestaltungen möglich, bei denen mehr als zwei Anschlusselemente 6, 6' vorhanden sind. Insbesondere können entsprechend den Darstellungen in den FIG 8 und 9 zwei äußere Anschlusselemente 6, 6' ein mittleres Anschlusselement 6" einrahmen.

Das dritte Anschlusselement 6" kann entsprechend der Darstellung in FIG 8 ebenfalls mit einem der Enden 2, 2' der Halbbrücke elektrisch verbunden sein. In diesem Fall ist vorzugsweise entsprechend der Darstellung in FIG 8 das mittlere Anschlusselement 6" mit einem der Enden 2, 2' der Halbbrücke elektrisch verbunden, die beiden äußeren Anschlusselemente 6, 6' mit dem anderen der Enden 2, 2' der Halbbrücke. Alternativ kann das dritte der Anschlusselemente 6, 6', 6" - vorzugsweise entsprechend der Darstellung in FIG 9 das mittlere Anschlusselement 6" - mit dem Knotenpunkt 4 der Halbbrücke verbunden sein. In diesem Fall ist entsprechend der Darstellung in FIG 9 das mittlere Anschlusselement 6" über (mindestens) einen weiteren Halbleiterschalter 3" an den Knotenpunkt 4 anschaltbar.

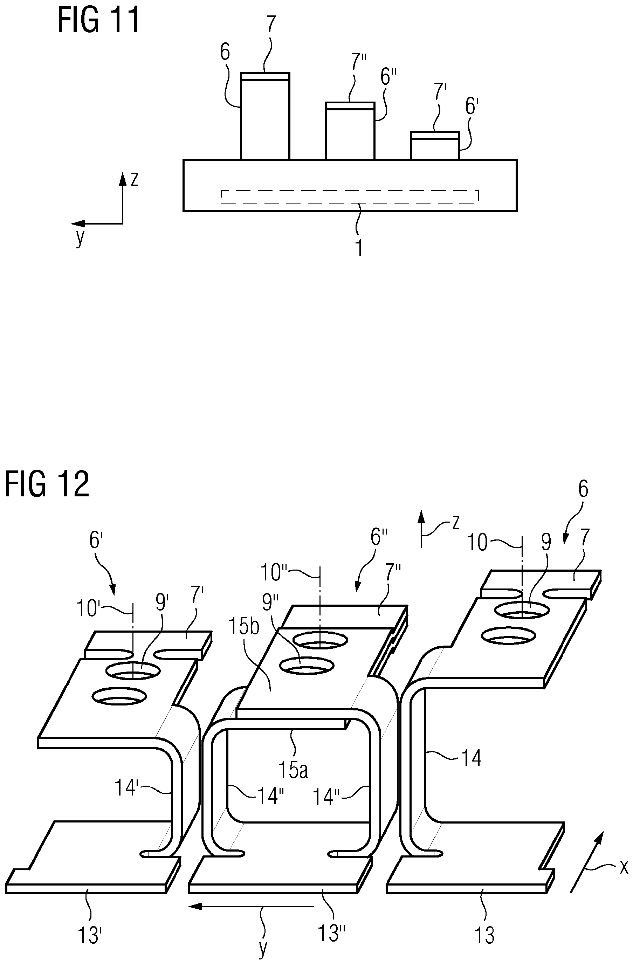

Im Falle der Ausgestaltung gemäß FIG 8, wenn also zwei der Anschlusselemente 6, 6', 6" mit demselben Ende 2, 2' der Halbbrücke verbunden sind, sind diese Anschlusselemente 6, 6', 6" somit über den Schaltungsträger 1 elektrisch miteinander kurzgeschlossen. Die Anschlussflächen 7, 7', 7" der miteinander kurz geschlossenen Anschlusselemente 6, 6', 6" - gemäß der Ausgestaltung von FIG 8 also der beiden äußeren Anschlusselemente 6, 6' - liegen vorzugsweise entsprechend der Darstellung in FIG 10 in Höhenrichtung z gesehen auf gleicher Höhe. Vorzugsweise gilt dies auch umgekehrt. Wenn also (bei mehr als zwei Anschlusselementen 6, 6', 6") Anschlusselemente 6, 6', 6" auf der gleichen Höhe liegen, so sind diese Anschlusselemente 6, 6', 6" vorzugsweise über den Schaltungsträger 1 elektrisch miteinander kurzgeschlossen. Im Falle der Ausgestaltung gemäß FIG 9 liegen hingegen vorzugsweise alle drei Anschlusselemente 6, 6', 6" auf voneinander verschiedenen Höhen. Dies ist in den FIG 11 und 12 dargestellt.

Unabhängig von der Anzahl an Anschlusselementen 6, 6', 6" sind die Anschlussflächen 7, 7', 7" der Anschlusselemente 6, 6', 6" parallel zum Schaltungsträger 1 orientiert. Weiterhin weisen die Anschlusselemente 6, 6', 6" zusätzlich zur jeweiligen Anschlussfläche 7, 7', 7" zum Schaltungsträger 1 hin jeweils eine parallel zum Schaltungsträger 1 orientierte Verbindungsfläche 13, 13', 13" auf. Die jeweilige Anschlussfläche 7, 7', 7" ist somit über die jeweilige Verbindungsfläche 13, 13', 13" elektrisch mit dem Schaltungsträger 1 verbunden. Die jeweilige Anschlussfläche 7, 7', 7" und die jeweilige Verbindungsfläche 13, 13', 13" sind über jeweils mindestens eine Zwischenfläche 14, 14', 14" mechanisch und elektrisch miteinander verbunden. Die Zwischenflächen 14, 14', 14" sind in der Regel orthogonal zu der Versatzrichtung orientiert, also in der Regel orthogonal zur Querrichtung y. In der Versatzrichtung gesehen ist zwischen je zwei in Versatzrichtung unmittelbar benachbarten Anschlusselementen 6, 6', 6" je eine Zwischenfläche 14, 14', 14" dieser beiden Anschlusselemente 6, 6', 6" angeordnet. Durch diese Ausgestaltung der Zwischenflächen 14, 14', 14" wird eine nieder induktive Anbindung der Anschlussflächen 7, 7', 7" mit den Verbindungsflächen 13, 13', 13" erreicht. Zwischen den Zwischenflächen 14, 14', 14" kann weiterhin ein Isoliermaterial angeordnet sein. Das Isoliermaterial kann beispielsweise in Form einer jeweiligen Zwischenwand ausgebildet sein, d.h. Bestandteil einer mechanischen Basisstruktur sein, auf welcher der Schaltungsträger 1 angeordnet ist. Die Zwischenwände sind nicht mit dargestellt.

Der guten Ordnung halber sei erwähnt, dass die Zwischenflächen 14, 14', 14" mit den Verbindungsflächen 13, 13', 13" und den Anschlussflächen 7, 7', 7" über entsprechende, gebogene Abschnitte des jeweiligen Anschlusselements 6, 6', 6" verbunden sind. Aufgrund des Umstands, dass die Anschlusselemente 6, 6', 6" als Stanz-Biege-Teile ausgebildet sind, ist das jeweilige Anschlusselement 6, 6', 6" als solches aber einstückig ausgebildet.

Wie bereits erwähnt, sind in der Minimalausgestaltung nur zwei Anschlusselemente 6, 6' vorhanden. In diesem Fall weisen die beiden Anschlusselemente 6, 6' entsprechend der Darstellung in FIG 2 jeweils exakt eine Zwischenfläche 14, 14' auf. Die Anzahl an Zwischenflächen 14, 14' pro Anschlusselement 6, 6' ist somit exakt eins. Es ist aber, wie ebenfalls bereits erwähnt, auch möglich, dass die Anzahl an Anschlusselementen 6, 6', 6" größer als zwei ist. In diesem Fall rahmen in der Versatzrichtung gesehen zwei äußere Anschlusselemente 6, 6' das mindestens eine mittlere Anschlusselement 6" ein. In diesem Fall weisen nur die beiden äußeren Anschlusselemente 6, 6' entsprechend der Darstellung in FIG 12 jeweils exakt eine Zwischenfläche 14, 14' auf. Die Anzahl an Zwischenflächen 14, 14' pro Anschlusselement 6, 6' ist somit exakt eins. Bei den mittleren Anschlusselementen 6" ist die Anzahl an Zwischenflächen 14" pro mittlerem Anschlusselement 6" hingegen exakt zwei.

Falls (mindestens) ein mittleres Anschlusselement 6" vorhanden ist, weist die Anschlussfläche 7" des mittleren Anschlusselements 6" entsprechend der Darstellung in FIG 12 vorzugsweise ein unteres und ein oberes Flächenelement 15a, 15b auf. Das untere Flächenelement 15a und das obere Flächenelement 15b sind in Höhenrichtung z gesehen übereinander angeordnet. Dadurch ist in Höhenrichtung z gesehen das untere Flächenelement 15a zwischen dem oberen Flächenelement 15b und der Verbindungsfläche 13" des mittleren Anschlusselements 6" angeordnet. Das untere und das obere Flächenelement 15a, 15b liegen flächig aneinander an. Dies gilt vorzugsweise bereits im belastungsfreien Zustand. Beispielsweise können die beiden Flächenelemente 15a, 15b durch einen entsprechenden Vorgang (beispielsweise Schrauben oder Schweißen) eigenständig miteinander verbunden werden. Zumindest gilt dies aber dann, wenn die Anschlussfläche 7" mit der entsprechenden Stromschiene 8" - beide in FIG 12 nicht mit dargestellt - verbunden ist. Ersichtlich ist je eines der beiden Flächenelemente 15a, 15b mit je einer der beiden Zwischenflächen 14" des mittleren Anschlusselements 6" mechanisch und elektrisch verbunden.

Zusammengefasst betrifft die vorliegende Erfindung somit folgenden Sachverhalt:
Ein Leistungshalbleitermodul weist einen Schaltungsträger 1 auf, auf der mindestens eine Halbbrücke angeordnet ist, die zwei Enden 2, 2' aufweist, die über mindestens zwei elektrisch in Reihe geschaltete Halbleiterschalter 3, 3' elektrisch miteinander verbunden sind. Das Leistungshalbleitermodul weist mehrere als Stanz-Biege-Teile ausgebildete Anschlusselemente 6, 6', 6" auf, wobei die Enden 2, 2' der Halbbrücke mit jeweils mindestens einem Anschlusselement 6, 6', 6" elektrisch verbunden sind. Die Anschlusselemente 6, 6', 6" weisen Anschlussflächen 7, 7', 7" zum Anschluss von Stromschienen 8, 8', 8" auf. Die Anschlussflächen 7, 7', 7" sind in einer Versatzrichtung um einen Seitenversatz δy gegeneinander versetzt angeordnet. Die Anschlussflächen 7, 7', 7" sind parallel zum Schaltungsträger 1 orientiert. Die Anschlusselemente 6, 6', 6" weisen weiterhin zusätzlich zu den Anschlussflächen 7, 7', 7" zum Schaltungsträger 1 hin parallel zum Schaltungsträger 1 orientierte Verbindungsflächen 13, 13', 13" auf, so dass die Anschlussflächen 7, 7', 7" über die Verbindungsflächen 13, 13', 13" elektrisch mit dem Schaltungsträger 1 verbunden sind. Die Anschlussflächen 7, 7', 7" und die Verbindungsflächen 13, 13', 13" sind über Zwischenflächen 14, 14', 14" mechanisch und elektrisch miteinander verbunden. In der Versatzrichtung y gesehen ist zwischen je zwei unmittelbar benachbarten Anschlusselementen 6, 6', 6" je eine Zwischenfläche 14, 14', 14" dieser beiden Anschlusselemente 6, 6', 6" angeordnet.

Die vorliegende Erfindung weist viele Vorteile auf. Aufgrund der Anordnung der Zwischenflächen 14, 14', 14" zwischen den entsprechenden Anschlussflächen 7, 7', 7" ist auch innerhalb des Leistungshalbleitermoduls eine niederinduktive Stromleitung realisiert. Aufgrund der in Höhenrichtung z versetzten Anordnung der Anschlussflächen 7, 7', 7" ist ein einfaches Anschließen der Stromschienen 8, 8', 8" möglich, wobei die Stromschienen 8, 8', 8" niederinduktiv geführt werden können. Das Schaltverhalten der Halbleiterschalter 3, 3' kann verbessert werden. Die Gesamtkosten können reduziert werden. Bei mehr als zwei Anschlussflächen 7, 7', 7" ergibt sich weiterhin der Vorteil, dass die induktive Kopplung aller Anschlussflächen 7, 7', 7" über die entsprechenden Zwischenflächen 14, 14', 14" sehr gleichmäßig ist. Die Vorteile der vorliegenden Erfindung zeigen sich insbesondere bei einem Leistungshalbleitermodul, das einen Drei- oder Multilevelumrichter realisiert.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Leistungshalbleitermodul,
- wobei das Leistungshalbleitermodul einen Schaltungsträger (1) aufweist,
- wobei auf dem Schaltungsträger (1) mindestens eine Halbbrücke angeordnet ist,
- wobei die Halbbrücke zwei Enden (2, 2') aufweist, die über mindestens zwei elektrisch in Reihe geschaltete Halbleiterschalter (3, 3') elektrisch miteinander verbunden sind,
- wobei das Leistungshalbleitermodul eine Mehrzahl von als jeweiliges Stanz-Biege-Teil ausgebildeten Anschlusselementen (6, 6', 6") aufweist,
- wobei die Enden (2, 2') der Halbbrücke mit jeweils mindestens einem der Anschlusselemente (6, 6', 6") elektrisch verbunden sind,
- wobei die Anschlusselemente (6, 6', 6") eine jeweilige Anschlussfläche (7, 7', 7") zum Anschluss einer jeweiligen Stromschiene (8, 8', 8") aufweisen,
- wobei die Anschlussflächen (7, 7', 7") in einer Versatzrichtung um einen Seitenversatz (δy) gegeneinander versetzt angeordnet sind,
- wobei die Anschlussflächen (7, 7', 7") der Anschlusselemente (6, 6', 6") parallel zum Schaltungsträger (1) orientiert sind,
- wobei die Anschlusselemente (6, 6', 6") zusätzlich zur jeweiligen Anschlussfläche (7, 7', 7") zum Schaltungsträger (1) hin jeweils eine parallel zum Schaltungsträger (1) orientierte Verbindungsfläche (13, 13', 13") aufweisen, so dass die jeweilige Anschlussfläche (7, 7', 7") über die jeweilige Verbindungsfläche (13, 13', 13") elektrisch mit dem Schaltungsträger (1) verbunden ist,
- wobei die jeweilige Anschlussfläche (7, 7', 7") und die jeweilige Verbindungsfläche (13, 13', 13") über jeweils mindestens eine Zwischenfläche (14, 14', 14") mechanisch und elektrisch miteinander verbunden sind,
**dadurch gekennzeichnet,**
**dass** in der Versatzrichtung gesehen zwischen je zwei in Versatzrichtung unmittelbar benachbarten Anschlusselementen (6, 6', 6") je eine Zwischenfläche (14, 14', 14") dieser beiden Anschlusselemente (6, 6', 6") angeordnet ist.

2. Leistungshalbleitermodul nach Anspruch 1,
**dadurch gekennzeichnet,**
**dass** die Anzahl an Anschlusselementen (6, 6') exakt zwei beträgt und dass die Anzahl an Zwischenflächen (14, 14') pro Anschlusselement (6, 6') exakt eins ist.

3. Leistungshalbleitermodul nach Anspruch 1,
**dadurch gekennzeichnet**
**dass** die Anzahl an Anschlusselementen (6, 6', 6") größer als zwei ist, so dass in der Versatzrichtung gesehen zwei äußere Anschlusselemente (6, 6') mindestens ein mittleres Anschlusselement (6") einrahmen, dass die Anzahl an Zwischenflächen (14, 14') pro äußerem Anschlusselement (6, 6') exakt eins ist und dass die Anzahl an Zwischenflächen (14") pro mittlerem Anschlusselement (6") exakt zwei ist.

4. Leistungshalbleitermodul nach Anspruch 3,
**dadurch gekennzeichnet,**
- **dass** die Anschlussflächen (7") der mittleren Anschlusselemente (6") jeweils ein unteres und ein oberes Flächenelement (15a, 15b) aufweisen,
- **dass** das jeweilige untere und das jeweilige obere Flächenelement (15a, 15b) übereinander angeordnet sind, so dass das untere Flächenelement (15a) zwischen dem oberen Flächenelement (15b) und der Verbindungsfläche (13") des jeweiligen mittleren Anschlusselements (6") angeordnet ist, das untere und das obere Flächenelement (15a, 15b) aber zumindest nach dem Verbinden mit der jeweiligen Stromschiene (8") flächig aneinander anliegen, und
- **dass** je eines der beiden Flächenelemente (15a, 15b) mit je einer der beiden Zwischenflächen (14") des jeweiligen mittleren Anschlusselements (6") mechanisch und elektrisch verbunden ist.

5. Leistungshalbleitermodul nach einem der obigen Ansprüche, **dadurch gekennzeichnet,**
- **dass** orthogonal zu den Anschlussflächen (7, 7', 7") orientierte Normalenvektoren parallel zueinander verlaufen und
- **dass** die Anschlussflächen (7, 7', 7") in Richtung der Normalenvektoren gesehen zumindest teilweise um einen Höhenversatz (δz) gegeneinander versetzt angeordnet sind.

6. Leistungshalbleitermodul nach Anspruch 5,
**dadurch gekennzeichnet,**
**dass** der Höhenversatz (δz) minimal 3 mm und/oder maximal 25 mm beträgt, besser minimal 8 mm oder 10 mm und/oder maximal 15 mm oder 20 mm.

7. Leistungshalbleitermodul nach Anspruch 5 oder 6,
**dadurch gekennzeichnet,**
**dass** in Richtung der Normalenvektoren gesehen auf gleicher Höhe liegende Anschlussflächen (7, 7', 7") über den Schaltungsträger (1) elektrisch miteinander kurzgeschlossen sind.
